# EUROPEAN PATENT APPLICATION

(11) **EP 2 799 559 A1**
(43) Date of publication of application: **05.11.2014**
(21) Application number: 12856791.4
(22) Date of filing: 25.06.2012
(51) Int. Cl.: C21D 1/34, B21D 24/00, H05B 3/10, C21D 1/18, C21D 1/673

(54) **INFRARED HEATING DEVICE**

(30) Priority: 15.12.2011 JP 2011275128
(71) Applicant: Toyoda Iron Works Co., Ltd., Toyota-shi Aichi 471-8507 (JP)
(72) Inventor: MINEOKA Keitaro, Toyota-shi Aichi 471-8507 (JP)
(74) Representative: TBK
(86) International application number: PCT/JP2012/066175
(87) International publication number: WO 2013/088764

(57) **Abstract**

Provided is an infrared heating device which has a high degree of freedom with respect to heating region shape setting, such as being able to set island-like low-temperature regions, when a shield member is placed away in a non-contacting manner from a member to be heated, without it being necessary for the rigidity of the shield member to be ensured. Because a retainer member (16) which allows near-infrared light (L) to pass through is disposed between infrared lamp heaters (12) and the member to be heated (14) and the shield member (18) is held by the retainer member (16), the shield member (18) can be placed away from the member to be heated (14), and heating of the shield member (18) due to heating of the member to be heated (14) can be suppressed, thereby preventing early deterioration of the shield member. In addition, the degree of freedom in setting the shapes of high-temperature heating regions (Hi) and low-temperature heating regions (Lo) is improved, for example, island-like low-temperature heating regions (Lo) can be formed by using island-like shield members (18b, 18c). Also, because there is no need to support the shield member (18) in a cantilevered manner, the plate thickness of the shield member (18) does not need to be increased to ensure rigidity, so the infrared heating device can be inexpensively constructed.

## Description

### TECHNICAL FIELD

The invention relates generally to an infrared heating apparatus, and more specifically to an improvement of an infrared heating apparatus that sets a heated region using a shielding member that restricts transmission of infrared rays.

### BACKGROUND ART

There has been known an infrared heating apparatus that irradiates a member to be heated (hereinafter, referred to as "to-be-heated member") with infrared rays from an infrared source to heat the to-be-heated member, and sets a heated region of the to-be-heated member with the use of a shielding member that restricts transmission of the infrared rays. An apparatus described in Patent Document 1 is an example of the above-described infrared heating apparatus, and used for, for example, partial heating of a steel sheet during hot press molding in which quenching is carried out at the same time as press molding. That is, a portion irradiated with infrared rays is heated up to a temperature equal to or higher than, for example, the Ac3 point temperature and is quenched and hardened by a press, whereas a shielded portion is kept at a low temperature lower than the Ac3 point temperature without being quenched and hardened, so as to be maintained under a low strength. Thus, a process of bending, drawing, punching or the like can be appropriately carried out in, for example, a low-strength region even after the hot press molding. Further, in the case of a vehicle structure, by appropriately setting a high-strength region and a low-strength region, it is possible to ensure a prescribed impact energy absorption performance and to adjust a deformation mode (e.g. deformation direction) at the time of a vehicle collision.

### PRIOR ART DOCUMENT

### PATENT DOCUMENT

Patent Document 1: Japanese Patent Application Publication No. 2010-44875

### SUMMARY OF THE INVENTION

### PROBLEMS TO BE SOLVED BY THE INVENTION

However, if a shielding member is directly disposed on a to-be-heated member and the to-be-heated member is irradiated with infrared rays, the shielding member is also heated due to direct heat transfer from the to-be-heated member, and thus the shielding member deteriorates early and needs to be replaced in a short period. If the shielding member is disposed apart from the to-be-heated member in a non-contact state, early deterioration caused by heating due to heat transfer is prevented. However, due to the presence of a holder that holds the shielding member, the flexibility in setting the shape of a heated region is lowered, for example, forming only a central portion of the to-be-heated member as a low-temperature region in the form of an island is not possible. In the case where the shielding member is supported in a cantilever manner, a prescribed stiffness needs to be ensured to prevent flexural deformation and thus the plate thickness of the shielding member increases, leading to a cost increase.

The invention is made in light of the above-described circumstances, and an object of the invention is to provide an infrared heating apparatus having a high degree of flexibility in setting the shape of a heated region, for example, such a flexibility that a low-temperature region can be set in the form of an island, and causing no need to ensure a stiffness of a shielding member, when the shielding member is disposed apart from a to-be-heated member in a non-contact state in order to prevent heating of the shielding member.

### MEANS FOR SOLVING THE PROBLEM

To achieve the object, the first aspect of the invention provides an infrared heating apparatus that irradiates a member to be heated with infrared rays from an infrared source to heat the member to be heated, and sets a heated region of the member to be heated with use of a shielding member that restricts transmission of the infrared rays, characterized in that a holding member that allows the infrared rays to be transmitted there through is disposed between the infrared source and the member to be heated, and the shielding member is held by the holding member.

The second aspect of the invention provides the infrared heating apparatus recited in the first aspect of the invention, characterized in that (a) the holding member includes a plurality of heat-resistant glass plates placed on each other in such a posture as to intersect with an irradiation direction of the infrared rays; and (b) the shielding member is a metal sheet, metal foil or a metal film, which is held between the plurality of heat-resistant glass plates.

The third aspect of the invention provides the infrared heating apparatus recited in the second aspect of the invention, characterized in that the shielding member is the metal film that is vapor-deposited on a surface of the heat-resistant glass plate other than the heat-resistant glass plate located nearest to the member to be heated, the surface being located on the member to be heated side, or on a surface of any one of the heat-resistant glass plates other than the heat-resistant glass plate located nearest to the member to be heated, the surface being located on the member to be heated side, among the plurality of heat-resistant glass plates.

### EFFECTS OF THE INVENTION

In the infrared heating apparatus, the holding member that allows the infrared rays to be transmitted therethrough is disposed between the infrared source and the member to be heated, and the shielding member is held by the holding member. Thus, the shielding member can be disposed apart from the member to be heated in a non-contact state. As a result, heating of the shielding member due to the heating of the member to be heated is restricted, and thus early deterioration of the shielding member is prevented. Further, the flexibility in setting the shapes of the heated regions is increased, for example, the low-temperature heated regions can be set in the shape of an island by using the shielding member in which only the middle of the member to be heated is shielded. In addition, it is not necessary to support the shielding member in a cantilever manner. Thus, it is not necessary to increase the plate thickness of the shielding member to ensure the stiffness. This allows the shielding member to be formed at low cost.

In the second aspect of the invention, the holding member is formed of a plurality of heat-resistant glass plates placed on each other, and the shielding member is formed of a metal sheet, metal foil or a metal film, which is held between the plurality of heat-resistant glass plates. Thus, there is not a possibility that the shielding member will become dirty or be deformed under the influence of heat, vapor or the like. Therefore, it is possible to enhance the durability of the shielding member and to facilitate maintenance since just washing the heat-resistant glass plates as necessary is required. Further, even if the shielding member is sharp or has elongate shapes, there is no possibility that the shielding member will be deformed under the influence of heat or atmosphere, and the shielding member can be thinned within a range in which transmission of the infrared rays can be restricted. Thus, the usage of the shielding member can be reduced, leading to cost reduction.

In the third aspect of the invention, the shielding member is formed of the metal film that is vapor-deposited on a surface of the heat-resistant glass plate other than the heat-resistant glass plate located nearest to the member to be heated, the surface being located on the member to be heated side, or on a surface of any one of the heat-resistant glass plates other than the heat-resistant glass plate located nearest to the member to be heated, the surface being located on the member to be heated side, among the plurality of heat-resistant glass plates. Therefore, even if the heat-resistant glass plate on the member to be heated is scratched due to contact with the member to be heated caused during installation or removal of the member to be heated on or from the heating apparatus, it is necessary to replace only the heat-resistant glass plate, and the shielding member can be still used as it is. Thus, it is possible to minimize the influence. Since the metal film that is directly formed on the heat-resistant glass plate through vapor deposition is used as the shielding member, small shielding portions or multiple shielding portions spaced apart from each other can be set more easily with a higher degree of accuracy and thus the flexibility in setting the shapes of the heated regions becomes higher, as compared with the case where an independently formed shielding member such as a metal sheet or metal foil is attached to or held between the heat-resistant glass plates.

### BRIEF DESCRIPTION OF THE DRAWINGS

FIG. 1 is a front view illustrating the schematic configuration of an infrared heating apparatus according to an embodiment of the invention.
FIG. 2 is a perspective view illustrating an example of the shielding member which is held between the plurality of silica glass plates in the infrared heating apparatus illustrated in FIG. 1.
FIG. 3 is a perspective view illustrating an example in which shades (the low-temperature heated regions) against the near infrared rays are created on the member to be heated by the shielding member illustrated in FIG. 2.
FIG. 4 is a perspective view illustrating an example of a press-molded article that is formed in a manner in which the member to be heated illustrated in FIG. 3 is subjected to hot press molding, and then trimming and punching are carried out.
FIG. 5 describes the shielding member of the infrared apparatus illustrated in FIG. 1 and the shielding member is interposed and held between the pair of silica glass plates.
FIG. 6 describes the shielding member of the infrared apparatus illustrated in FIG. 1 and the shielding member is vapor-deposited metal film on the surface of either of the pair of the silica glass plates.

### MODES FOR CARRYING OUT THE INVENTION

The infrared heating apparatus according to the invention is used for, for example, partial heating of a steel sheet during hot press molding in which quench hardening is carried out at the same time as press molding. That is, a portion irradiated with infrared rays is heated up to a temperature equal to or higher than, for example, the Ac3 point temperature and is quenched and hardened by a press mold process, whereas a shielded portion is kept at a low temperature lower than the Ac3 point temperature without being quenched and hardened, so as to be maintained under a low strength. Thus, a process of bending, drawing, punching or the like, or spot welding can be appropriately carried out in, for example, a low-strength region even after the hot press molding. Further, in the case of a vehicle structure, by appropriately setting a high-strength region and a low-strength region, it is possible to ensure a prescribed impact energy absorption performance and to adjust a deformation mode (e.g. deformation direction) at the time of a vehicle collision. A steel sheet for hot press molding is preferably used as the member to be heated, and is subjected to hot press molding after partial heating performed by the infrared heating apparatus according to the invention. Thus, a high-strength region (high-temperature heated region) that is quenched and hardened, and a low-strength region (low-temperature heated region) are formed in a prescribed pattern.

The infrared source is a device that irradiates infrared rays, and an infrared lamp heater is preferably used as the infrared source. As the infrared rays, near infrared rays having short wavelengths are preferable since heating is performed more efficiently. The shielding member just needs to be a member that reflects or absorbs the infrared rays to reduce the transmission amount, but a member having a high reflectance is desirable with a view to restricting deterioration due to heating of itself. For example, a gold thin sheet, gold foil or a gold vapor-deposited film, which is difficult to oxidize and which has a high reflectance of the near infrared rays, is preferably used. However, there may be used a metal such as sliver or aluminum having a higher ability to reflect the infrared rays than that of the member to be heated, or a member obtained by applying, for example, gold coating to an inorganic material that is excellent in heat resistance.

Heat-resistant glass such as silica glass or borosilicate glass is preferably used as the holding member that allows the infrared rays to be transmitted therethrough. The holding member need not allow 100% of the infrared rays to be transmitted therethrough as long as the holding member has a high infrared transmission factor (for example, a near infrared transmission factor of equal to or higher than 80% is preferable). It is preferable that the multiple heat-resistant glass plates be placed on each other and the shielding member be held between the glass plates, as in the second invention. However, the shielding member may be attached to or vapor-deposited on one surface of a single heat-resistant glass plate, for example, on a surface on the opposite side from the member to be heated. There may be adopted methods of allowing the holding member to hold the shielding member, other than interposition, attachment and vapor-deposition. For example, a liquid metal is poured into a recessed portion having a prescribed shape and formed in the shielding member, is solidified under cooling so as to be integrated with the holding member, and then used as the shielding member.

### EMBODIMENTS

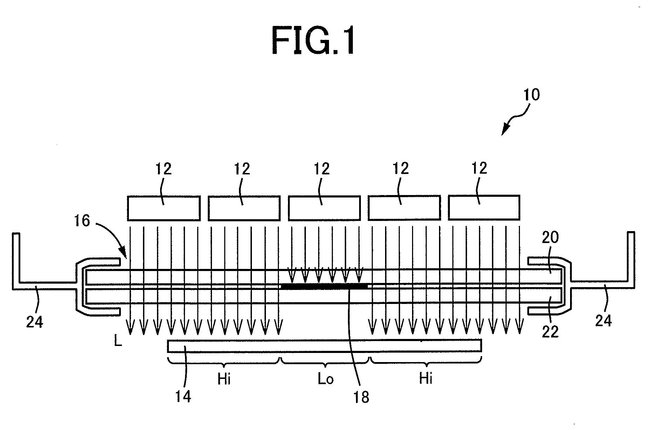

Hereinafter, embodiments of the invention will be described in detail with reference to the drawings. FIG. 1 is a front view illustrating the schematic configuration of an infrared heating apparatus 10 according to an embodiment of the invention. The infrared heating apparatus 10 includes, as infrared sources, a plurality of near infrared lamp heaters 12 that are disposed substantially horizontally. Immediately below the near infrared lamp heaters 12, a member 14 to be heated (hereinafter, referred to as "to-be-heated member 14") is introduced by a loader unit (e.g. a conveyer) (not illustrated). The to-be-heated member 14 is a flat steel sheet for hot press, and is supported in a substantially horizontal posture and heated by being irradiated with near infrared rays (arrows L) emitted directly downward from the near infrared lamp heaters 12.

A holding member 16 is disposed at an intermediate position between the near infrared lamp heaters 12 and the to-be-heated member 14, and holds a shielding member 18 that has a prescribed shape and that restricts transmission of the near infrared rays L. The holding member 16 includes a pair of a flat upper silica glass plate 20 and a flat lower silica glass plate 22 that allow the near infrared rays L to be transmitted therethrough. The upper and lower silica glass plates 20, 22 are disposed so as to be placed on each other in a substantially horizontal posture, that is, in such a posture as to be substantially orthogonal to the near infrared rays L emitted from the near infrared lamp heaters 12, and are supported, at their peripheral edge portions located outside an irradiation range of the near infrared rays L, by a plurality of stays (supports) 24, at positions apart upward from the to-be-heated member 14. The silica glass plates 20, 22 correspond to heat-resistant glass plates.

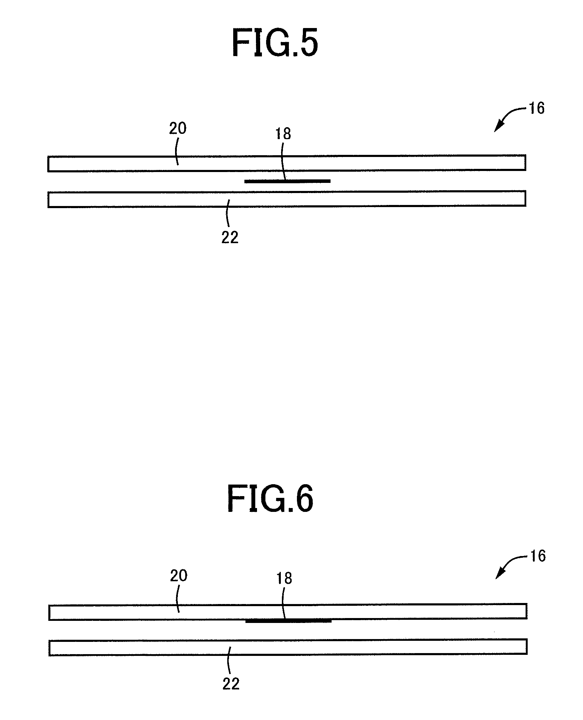

The shielding member 18 is formed of gold foil (having a thickness of approximately 1 µm) that is difficult to oxidize and that has a high reflectance of the near infrared rays L, and is interposed and held between the pair of the upper silica glass plate 20 and the lower silica glass plate 22, as illustrated in FIG. 5. Although there is a clearance between the silica glass plates 20, 22 in order to indicate the shielding member 18 in FIG. 1, the pair of the upper silica glass plate 20 and the lower silica glass plate 22 are actually placed on each other so as to be in close contact with each other because the shielding member 18 has a thickness of approximately 1 µm, which is considerably thin. At a portion where the shielding member 18 described above is disposed, transmission of the near infrared rays L is interrupted. Thus, shades against the near infrared rays L are created on the to-be-heated member 14 and heating is restricted. As a result, high-temperature heated regions Hi that are irradiated with the near infrared rays L and low-temperature heated regions Lo corresponding to shade portions are formed in a prescribed pattern corresponding to the shape of the shielding member 18.

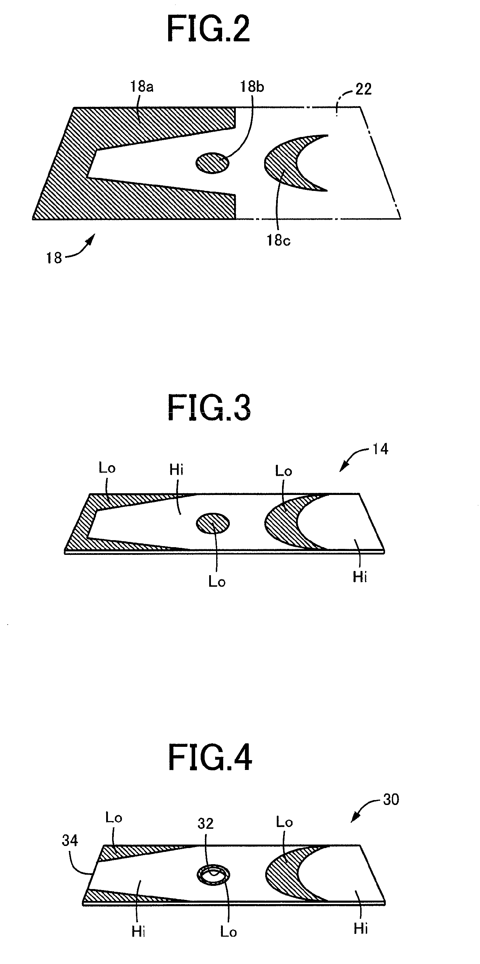

FIG. 2 is a perspective view concretely illustrating an example of the shielding member 18 formed of three shielding members 18a to 18c including the shielding members 18b, 18c each of which is in the form of an island. FIG. 3 illustrates an example of the high-temperature heated regions Hi and the low-temperature heated regions Lo that are formed on the to-be-heated member 14 by the shielding member 18 illustrated in FIG. 2. The high-temperature heated regions Hi are heated up to a temperature equal to or higher than the Ac3 point temperature, whereas the low-temperature heated regions Lo are kept at a low temperature lower than the Ac3 point temperature. The to-be-heated member 14 partially heated by the infrared heating apparatus 10 in the above-described manner is then subjected to hot press molding. Thus, the high-temperature heated regions Hi are quenched and hardened to have a high strength, whereas the low-temperature heated regions Lo are not quenched and hardened so as to be maintained under a low strength. The portions having a low strength can be processed by cutting, punching or the like more easily than the portions having a high strength. For the portions having a low strength, the conditions for spot-welding are eased. FIG. 4 illustrates an example of a press-molded article 30 that is formed in a manner in which the to-be-heated member 14 is partially heated by the infrared heating apparatus 10 and subjected to hot press molding, and then punching 32 and trimming 34 are carried out on the low-temperature heated regions (low-strength portions) Lo.

As described above, in the infrared heating apparatus 10 in the present embodiment, the holding member 16 that allows the near infrared rays L to be transmitted therethrough is disposed between the near infrared lamp heaters 12 and the to-be-heated member 14 and the shielding member 18 is held by the holding member 16. Thus, the shielding member 18 can be disposed apart from the to-be-heated member 14 in a non-contact state. As a result, heating of the shielding member 18 due to the heating of the to-be-heated member 14 is restricted, and thus early deterioration of the shielding member 18 is prevented.

Further, the flexibility in setting the shapes of the high-temperature heated regions Hi and the low-temperature heated regions Lo is increased, for example, the low-temperature heated regions Lo can each be formed in the shape of an island by using the shielding member 18b, 18c in the shape of the island. In addition, it is not necessary to support the shielding member 18 in a cantilever manner. Thus, it is not necessary to increase the plate thickness of the shielding member 18 to ensure the stiffness. This allows the shielding member 18 to be formed at low cost.

Further, in the present embodiment, the holding member 16 is formed of the pair of the upper silica glass plate 20 and the lower silica glass plate 22 that are placed on each other, and the shielding member 18 is formed of gold foil interposed and held between the pair of the silica glass plates 20, 22. Thus, there is not a possibility that the shielding member 18 will become dirty or be deformed under the influence of heat, vapor or the like. Therefore, it is possible to enhance the durability of the shielding member 18, and to facilitate maintenance since just washing the surfaces of the silica glass plates 20, 22 as necessary is required. That is, if the shielding member 18 becomes dirty or dust adheres to the shielding member 18, the dirt absorbs the near infrared rays L and thus heated. This causes a possibility of early deterioration of the shielding member 18. Further, if the holding member 16 becomes dirty, the efficiency of heating the to-be-heated member 14 may be lowered. However, the shielding member 18 is interposed and held between the pair of the silica glass plates 20, 22, and therefore there is no possibility that the shielding member 18 will become dirty. Further, the dirt that adheres to the silica glass plates 20, 22 can be removed relatively easily, and therefore the maintenance can be easily performed.

Further, even if the members 18a to 18c of the shielding member 18 are sharp or have elongate shapes, there is no possibility that the members 18a to 18c will be deformed under the influence of heat or atmosphere, and the members 18a to 18c can be thinned within a range in which transmission of the near infrared rays L can be restricted. Thus, the usage of the shielding member 18, that is, the usage of gold foil can be reduced, leading to cost reduction.

Further, the shielding member 18 is interposed and held between the pair of the silica glass plates 20, 22. Therefore, even if the lower silica glass plate 22 on the to-be-heated member side, that is, on the lower side is scratched due to contact with, for example, the to-be-heated member 14 caused during installation or removal of the to-be-heated member 14 on or from the infrared heating apparatus 10, it is necessary to replace only the lower silica glass plate 22, and the shielding member 18 can be still used as it is. Thus, it is possible to minimize the influence.

Note that, if the shielding member 18 is disposed so as to be in contact with the to-be-heated member 14, the contact faces are not exposed to the atmosphere (air containing oxygen) and thus the surface of the to-be-heated member 14 is not oxidized during heating. However, during removal of the shielding member 18 after the completion of the heating, there is a possibility that the to-be-heated member 14 heated up to a high temperature will cause intense oxidation reaction (combustion) due to exposure to the atmosphere and a plated layer made of zinc, aluminum or the like, and applied to the to-be-heated member 14 will evaporate. However, in the present embodiment, since the shielding member 18 is held by the holding member 16 and is disposed apart upward from the to-be-heated member 14 in a non-contact state, there is no possibility that the plated layer on the to-be-heated member 14 will evaporate due to abrupt oxidation reaction as described above.

Meanwhile, in the embodiment described above, gold foil is used as the shielding member 18 and is interposed and held between the pair of the silica glass plates 20, 22. However, as illustrated in FIG. 6, gold may be vapor-deposited onto the lower face of the upper silica glass plate 20 located on the side opposite from the to-be-heated member 14, that is, onto the face on the to-be-heated member 14 side, and a vapor-deposited film may be used as the shielding member 18. FIG. 5 and FIG. 6 illustrate the pair of the silica glass plates 20, 22 in a state where they are spaced from each other, in order to clarify the difference between the both cases described above, but the silica glass plates 20, 22 are placed on each other so as to be in close contact with each other during the actual use.

In the case where the gold vapor-deposited film that is directly formed on the upper silica glass plate 20 through vapor deposition is used as the shielding member 18 as illustrated in FIG. 6, small shielding portions or multiple shielding portions spaced apart from each other can be set more easily with a higher degree of accuracy and thus the flexibility in setting the shapes of the high-temperature heated regions Hi and the low-temperature heated regions Lo becomes higher, as compared with the case where independently formed gold foil is used as the shielding member 18 and is held between the pair of the silica glass plates 20, 22 as in the above-described embodiment.

While the embodiments of the invention have been described above in detail with reference to the drawings, each of the embodiments is merely one mode for carrying out the invention, and the invention may be implemented in various other modes obtained by making various modifications and improvements to the embodiments on the basis of knowledge of a person skilled in the art.

### NOMENCLATURE OF ELEMENTS

10: infrared heating apparatus 12: near infrared lamp heaters (infrared source) 14: to-be-heated member 16: holding member 18, 18a to 18c: shielding member 20: upper silica glass plate (heat-resistant glass plates) 22: lower silica glass plate (heat-resistant glass plates) Hi: high-temperature heated regions Lo: low-temperature heated regions

## Claims

1. An infrared heating apparatus that irradiates a member to be heated with infrared rays from an infrared source to heat the member to be heated, and sets a heated region of the member to be heated with use of a shielding member that restricts transmission of the infrared rays, **characterized in that**
a holding member that allows the infrared rays to be transmitted therethrough is disposed between the infrared source and the member to be heated, and the shielding member is held by the holding member.

2. The infrared heating apparatus according to claim 1, **characterized in that**:
the holding member includes a plurality of heat-resistant glass plates placed on each other in such a posture as to intersect with an irradiation direction of the infrared rays; and
the shielding member is a metal sheet, metal foil or a metal film, which is held between the plurality of heat-resistant glass plates.

3. The infrared heating apparatus according to claim 2, **characterized in that** the shielding member is the metal film that is vapor-deposited on a surface of the heat-resistant glass plate other than the heat-resistant glass plate located nearest to the member to be heated, the surface being located on the member to be heated side, or on a surface of any one of the heat-resistant glass plates other than the heat-resistant glass plate located nearest to the member to be heated, the surface being located on the member to be heated side, among the plurality of heat-resistant glass plates.
